Europäisches Patentamt

European Patent Office

Office européen des brevets

(19)

(11) **EP 0 401 926 B1**

(12) **FASCICULE DE BREVET EUROPEEN**

(45) Date de publication et mention
de la délivrance du brevet:
**02.01.1997 Bulletin 1997/01**

(51) Int Cl.$^6$: **G06F 15/80**

(21) Numéro de dépôt: **90201420.8**

(22) Date de dépôt: **05.06.1990**

(54) **Procédé de traitement, stucture de réseau de neurones mettant en oeuvre le procédé et ordinateur pour simuler ladite structure de réseau de neurones**

Verarbeitungsverfahren, neuronale Netzwerkstruktur und Rechner zur Simulation einer solchen neuronalen Netzwerkstruktur

Processing method, neural network structure and computer for simulating said neural network structure

(84) Etats contractants désignés:
**CH DE FR GB IT LI SE**

(30) Priorité: **09.06.1989 FR 8907661**

(43) Date de publication de la demande:
**12.12.1990 Bulletin 1990/50**

(73) Titulaires:
- **LABORATOIRES D'ELECTRONIQUE PHILIPS S.A.S.**
  **94450 Limeil-Brévannes (FR)**
  Etats contractants désignés:
  **FR**
- **Philips Electronics N.V.**
  **5621 BA Eindhoven (NL)**
  Etats contractants désignés:
  **CH DE GB IT LI SE**

(72) Inventeur: **Sirat, Jacques-Ariel,**
**Société Civile S.P.I.D.**
**F-75007 Paris (FR)**

(74) Mandataire: **Landousy, Christian et al**
**Société Civile S.P.I.D.**
**156, Boulevard Haussmann**
**75008 Paris (FR)**

(56) Documents cités:
**WO-A-88/07234**

- **PROCEEDINGS OF THE 1987 IEEE INTERNATIONAL CONFERENCE ON SYSTEMS, MAN, AND CYBERNETICS, 20-23 octobre 1987, Virginia, vol. 2 de 3, pages 848-852; OMIDVAR et al.: "Analytical modeling of neuronal learning processes"**
- **NEURAL NETWORKS ABSTRACTS OF THE FIRST ANNUAL INT. MEETING, Boston, 1988, vol. 1, page 355, supplément 1; PAULOS et al.: "A VLSI architecture for feedforward networks with integral back-propagation"**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

**Description**

L'invention concerne un procédé de traitement mis en oeuvre dans une structure de réseau de neurones qui détermine des potentiels $y_k$ de neurones de sortie k à partir des états $x_l$ de neurones d'entrée l qui leur sont connectés selon des coefficients synaptiques $C_{kl}$, et qui effectue des phases d'apprentissage du réseau de neurones en déterminant des coefficients synaptiques nouveaux $C_{kl}^{(n)}$.

Elle concerne également un réseau de neurones qui met en oeuvre le procédé, et un calculateur programmé pour simuler un tel réseau.

Les réseaux de neurones trouvent leurs applications dans le traitement d'image, de la parole...

Les réseaux de neurones sont constitués d'automates connectés entre eux par des synapses auxquelles sont affectés des coefficients synaptiques. Ils permettent de traiter des problèmes qui le sont difficilement par les ordinateurs séquentiels classiques.

Pour effectuer un traitement donné, les réseaux de neurones doivent au préalable apprendre à l'effectuer. Cette phase appelée apprentissage fait appel à des exemples.

Pour de nombreux algorithmes, les résultats que l'on doit obtenir en sortie avec ces exemples sont généralement connus à l'avance. Dans un premier temps le réseau de neurones qui n'est pas encore adapté à la tâche prévue, va délivrer des résultats erronés. On détermine alors une erreur $E^p$ entre les résultats obtenus et ceux que l'on aurait dû obtenir et, à partir d'un critère d'adaptation, on modifie les coefficients synaptiques pour permettre au réseau de neurones d'apprendre l'exemple choisi. Cette étape est réitérée sur le lot d'exemples considérés comme nécessaires à un apprentissage satisfaisant du réseau de neurones.

Une méthode très répandue pour opérer cette adaptation, dans le cas de réseaux en couches, est celle de la rétropropagation du gradient. Pour cela on détermine les composantes du gradient $g_{j,L}$ de l'erreur $E^p$ précédente (calculée sur la dernière couche L) par rapport à chaque potentiel $y_{j,L}$ de chaque neurone. Ces composantes sont ensuite rétropropagées dans le réseau de neurones. Les potentiels $y_{j,L}$ sont déterminés avant l'application de la fonction non linéaire.

Cette méthode est par exemple décrite dans :

- D.E. Rumelhart, D.E. Hinton, and R.J. Williams, "Learning Internal Representation by Error Propagation", in D.E. Rumelhart, and J.L. McClelland (Eds), "Parallel Distributed Processing : Exploration in the Microstructure of Cognition", Vol.1, Foundations, MIT Press (1986).

La rétropropagation du gradient fait partie des nombreuses règles d'apprentissage qui peuvent se mettre sous la forme :

$$C_{kl}^{(n)} = C_{kl} + \Delta_k \cdot x_l$$

où $C_{kl}$ et $C_{kl}^{(n)}$ sont respectivement les coefficients synaptiques anciens et nouveaux,
$\Delta_k$ est un incrément qui dépend uniquement du neurone de sortie k,
$x_l$ est l'état du neurone d'entrée l.

Ces règles appartiennent à la famille des règles Hebbienne. Certaines de ces règles font usage du calcul de la norme $m_k$ du vecteur synaptique $C_k$ dont les composantes $C_{kl}$ sont les coefficients synaptiques associés à un même neurone de sortie k :

$$m_k = \sum_{l=1}^{N} (C_{kl})^2 \qquad 1 \leqslant l \leqslant N \quad .$$

Or, ces règles peuvent être mises en oeuvre dans des structures de réseau de neurones à traitement parallèle. Dans ce cas l'organisation de telles structures permet un traitement rapide des données qui aboutit à la fin des étapes d'apprentissage au calcul des nouveaux coefficients synaptiques.

Lorsque ceux-ci ont été calculés, il est alors possible de déterminer leurs normes respectives pour être mises en oeuvre dans la règle d'apprentissage considérée.

Ainsi la structure de réseau de neurones à traitement parallèle, initialement prévue pour accélérer le traitement, se trouve ainsi pénalisée par des étapes séquentielles qui nécessitent des appels des coefficients synaptiques en mémoire et des opérations arithmétiques supplémentaires.

Le problème posé est donc d'effectuer le calcul des normes des nouveaux coefficients synaptiques sans pénaliser la vitesse d'exécution des structures à traitement parallèle ainsi que celles ayant d'autres types de traitement.

La solution consiste en un procédé qui effectue un calcul de la norme

$$m_k^{(n)} = \sum_l (C_{kl}^{(n)})^2$$

des nouveaux coefficients synaptiques en additionnant à la norme des coefficients synaptiques précédents des termes relatifs aux mises à jour desdits coefficients synaptiques précédents.

Avantageusement les appels en mémoire des coefficients synaptiques sont supprimés et le nombre d'opérations arithmétiques, qui serait au moins égal au nombre de neurones I d'entrée dans chaque cas, est considérablement réduit.

Selon ce procédé pour calculer la nouvelle norme $m_k^{(n)}$ relative aux I nouveaux coefficients synaptiques $C_{kl}^{(n)}$ qui convergent vers le neurone k tel que :

$$m_k^{(n)} = \sum_l (C_{kl}^{(n)})^2,$$

on exploite les valeurs précédentes $m_k$ avec

$$m_k = \sum_l (C_{kl})^2$$

auxquelles on ajoute un incrément qui se décompose en plusieurs termes qui sont accessibles avant que les nouveaux coefficients synaptiques eux-mêmes aient été calculés.

Dans un mode particulier la norme nouvelle $m_k^{(n)}$ peut s'écrire :

$$m_k^{(n)} = \sum_l (C_{kl} + \Delta_k \cdot x_l)^2$$

soit :

$$m_k^{(n)} = \sum_l (C_{kl})^2 + 2 \Delta_k \cdot \sum_l C_{kl} \cdot x_l + \Delta_k^2 \sum_l (x_l)^2$$

Le terme

$$\sum_l C_{kl} \cdot x_l$$

correspond au traitement effectué par le réseau de neurones au début de chaque phase d'apprentissage.

Le terme

$$\sum_l (C_{kl})^2$$

est l'ancienne norme.

Le terme

$$\sum_{l} (x_l)^2$$

est la norme du vecteur d'états de neurones d'entrée.

Selon l'invention ces différents termes sont soit prélevés soit calculés avant la fin de l'étape de calcul des nouveaux coefficients synaptiques $C_{kl}^{(n)}$. Ainsi la norme de ces coefficients peut être déterminée sans calculer les nouveaux coefficients synaptiques eux-mêmes en utilisant en commun des étapes déjà effectuées par l'apprentissage.

Pour cela selon l'invention le procédé comprend les étapes suivantes :

A - détermination des potentiels $y_k$ des neurones de sortie k tel que :

$$y_k = \sum_l C_{kl} \cdot x_l$$

$B_1$ - mise en oeuvre des étapes d'apprentissage et détermination des variations subséquentes $\Delta_k$ à affecter aux états de neurones d'entrée,

$B_2$ - par ailleurs, détermination pour un neurone de sortie k de la norme $(x_l)^2$ des états de neurones d'entrée qui convergent sur le neurone k,

C - détermination de la norme $m_k^{(n)}$ tel que :

$$m_k^{(n)} = m_k + 2 \Delta_k \cdot y_k + (\Delta_k)^2 \cdot \sum_l (x_l)^2$$

où $m_k$ est la norme précédente.

Dans un mode plus général les règles d'apprentissage peuvent également être présentées sous la forme d'un terme de correction $\delta C_{kl}$ à appliquer à un coefficient synaptique précédent pour en déduire un nouveau coefficient synaptique. Dans ce cas pour un neurone de sortie k quelconque le procédé peut comprendre les étapes suivantes :

- détermination de premiers termes $(\delta C_{kl})^2$ pour chaque correction $\delta C_{kl}$ à appliquer à chaque coefficient synaptique $C_{kl}$ d'un neurone de sortie k,
- détermination de seconds termes $2C_{kl}.\delta C_{kl}$ correspondants,
- lecture de la norme précédente dans une unité de stockage de normes,
- sommation de ces premiers et seconds termes et de la norme précédente pour tous les coefficients synaptiques se rapportant à un neurone de sortie k pour déterminer la nouvelle norme $m_k^{(n)}$ des nouveaux coefficients synaptiques et mise à jour dans l'unité de stockage de normes.

Un calculateur programmé peut mettre en oeuvre les étapes du procédé.

Ce procédé peut être également mis en oeuvre dans un réseau de neurones munie de moyens de détermination des potentiels $y_k$ de neurones de sortie k à partir des états $x_l$ de neurones d'entrée l qui leur sont connectés selon des coefficients synaptiques $C_{kl}$, et de moyens pour effectuer des phases d'apprentissage du réseau de neurones en déterminant des coefficients synaptiques nouveaux $C_{kl}^{(n)}$ caractérisé en ce qu'elle comprend des moyens de calcul de la norme

$$m_k^{(n)} = \sum_l (C_{kl}^{(n)})^2$$

des nouveaux coefficients synaptiques en additionnant à la norme des coefficients synaptiques précédents des termes relatifs aux mises à jour desdits coefficients synaptiques précédents.

Ce réseau comprend :

. une unité de traitement qui détermine les potentiels $y_k$ des neurones de sortie en opérant en parallèle sur tous les neurones d'entrée l tel que :

$$y_k = \sum_l C_{kl} \cdot x_l$$

et qui détermine les termes relatifs auxdites mises à jour pour calculer des nouveaux coefficients synaptiques $C_{kl}^{(n)}$ tel que :

$$(1) \qquad C_{kl}^{(n)} = C_{kl} + \Delta_k \cdot x_l$$

où $\Delta_k$ est un incrément lié au neurone de sortie k,

. une unité de stockage du vecteur des normes précédentes $m_k$ relatives à chaque neurone de sortie k,

. une unité de calcul de la norme

$$\sum_l (x_l)^2$$

de chaque vecteur d'états $x_l$,

. une unité de calcul qui détermine les nouvelles normes $m_k^{(n)}$ à partir des normes

$$\sum_l (x_l)^2$$

et des incréments $\Delta_k$, et des potentiels des neurones de sortie $y_k$ issus de l'unité de traitement tel que :

$$m_k^{(n)} = m_k + 2\,\Delta_k \cdot y_k + (\Delta_k)^2 \cdot \sum_l (x_l)^2 \; .$$

Selon le mode plus général le réseau comprend :

- une unité de stockage du vecteur de normes précédentes $m_k$ relatives à chaque neurone de sortie k,
- un élévateur au carré déterminant des premiers termes $(\delta C_{kl})^2$ pour chaque correction à appliquer à chaque coefficient synaptique $C_{kl}$ d'un neurone de sortie k,
- un organe de multiplication déterminant des seconds termes $2C_{kl} \cdot \delta C_{kl}$ correspondants,
- un sommateur sommant ces premiers et seconds termes avec la norme précédente $m_k$ pour tous les coefficients synaptiques se rapportant à un neurone de sortie k afin de déterminer la nouvelle norme $m_k^{(n)}$ des nouveaux coefficients synaptiques $C_{kl}^{(n)}$ et mise à jour dans l'unité de stockage de normes.

Ainsi avec le procédé ou le réseau selon l'invention il est possible de connaître les normes nouvelles $m_k^{(n)}$ sans avoir à connaître les valeurs actualisées $C_{kl}^{(n)}$. Ainsi avantageusement on ne perd pas le bénéfice du parallélisme du calcul des coefficients synaptiques dans le cas d'un traitement parallèle. Même lorsque le traitement est effectué en série le procédé réduit la durée du traitement.

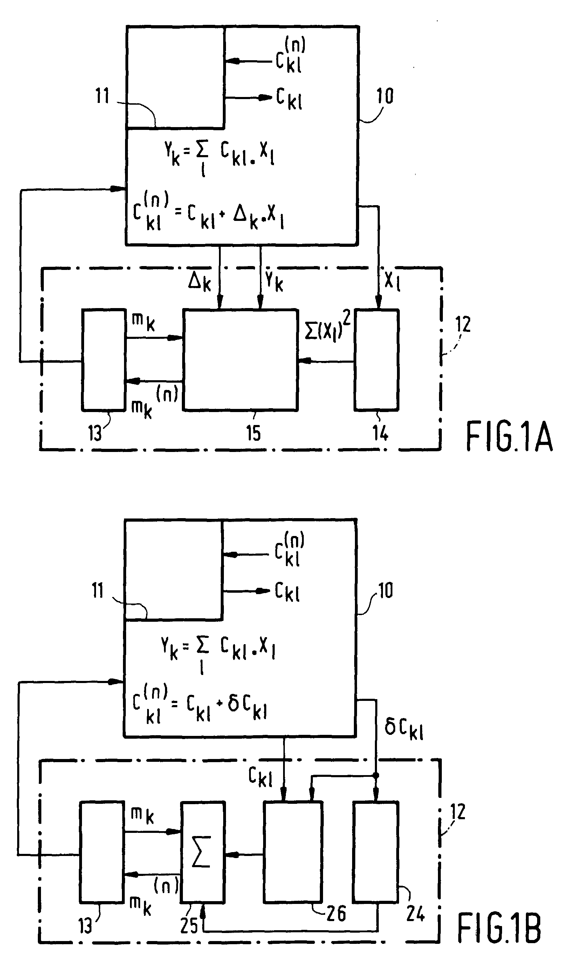

L'invention sera mieux comprise à l'aide des figures 1A, 1B données à titre d'exemple, qui représentent deux schémas de la structure de réseau de neurones munie de moyens permettant de déterminer les normes nouvelles.

Le réseau de neurones de la figure 1A comprend une unité de traitement 10 munie d'une mémoire 11 de coefficients synaptiques. L'unité de traitement 10 effectue l'ensemble des opérations nécessaires au fonctionnement d'un réseau de neurones soit :

- calculer les potentiels des neurones de sortie $y_k$ à partir des entrées des neurones $x_l$ et des coefficients synaptiques $C_{kl}$ selon :

$$y_k = \sum_l C_{kl} \cdot x_l$$

- calcul des nouveaux états de neurones de sortie $Y_k^{(n)}$ par application d'une fonction non linéaire F :

$$Y_k^{(n)} = F(y_k),$$

- mise en oeuvre d'une méthode d'apprentissage telle, par exemple, que la rétropropagation du gradient qui permet de déterminer le changement de coefficients synaptiques à effectuer pour que le réseau de neurones s'adapte, à l'aide d'exemples, à la tâche prévue tel que :

$$C_{kl}^{(n)} = C_{kl} + \Delta_k \cdot x_l \qquad (1)$$

$C_{kl}^{(n)}$ est le nouveau coefficient synaptique qui réactualise l'ancien coefficient synaptique $C_{kl}$,
$x_l$ sont les états des neurones d'entrée
$\Delta_k$ est un incrément, relatif au neurone de sortie k, qui est déterminé au cours de la phase d'apprentissage. Par exemple il tient compte des variations des états de neurones d'entrée qui sont déterminés par exemple selon la méthode de rétropropagation du gradient et qui doivent être répercutés sur les coefficients synaptiques. Il peut également tenir compte de l'ancienne norme $m_k$.

Au cours du traitement habituel effectué dans un réseau de neurones, l'unité de traitement 10 peut fournir pour un neurone de sortie k donné des quantités $\Delta_k$, $y_k$ et $x_l$.
Selon l'invention ces quantités sont transmises à un opérateur de normes 12. Celui-ci comprend :

- une unité de stockage 13 du vecteur des normes relatives à tous les neurones de sortie,
- une unité de calcul 14 de la norme

$$\sum_l (x_l)^2$$

concernant les l neurones d'entrée,
- et une unité de calcul 15 qui reçoit :

  . l'ancienne norme $m_k$ à partir de l'unité de stockage 13
  . la norme du vecteur d'état

$$\sum_l (x_l)^2$$

à partir de l'unité de calcul 14
  . le potentiel $y_k$ du neurone de sortie k et l'incrément $\Delta_k$ propre à ce neurone de sortie k.

L'unité de calcul 15 détermine ainsi la nouvelle norme $m_k^{(n)}$ tel que :

$$m_k^{(n)} = m_k + 2 \Delta_k \cdot y_k + (\Delta_k)^2 \cdot \sum_l (x_l)^2 .$$

Cette nouvelle norme $m_k^{(n)}$ est réécrite dans l'unité de stockage 13 à la place de l'ancienne norme $m_k$ pour être utilisée au cycle suivant (connexion 16).
Cet opérateur de norme 12 peut être utilisé pour appliquer toutes les règles d'apprentissage opérant selon l'équation (1) et qui ont besoin de ce calcul de norme pour effectuer l'apprentissage.

EP 0 401 926 B1

Selon le mode généralisé représenté sur la figure 1B l'opérateur de normes 12 reçoit du réseau de neurones 10, pour un neurone de sortie k quelconque, les coefficients synaptiques $C_{kl}$ et les corrections $\delta C_{kl}$ correspondantes. Dans ce cas l'opérateur de normes comprend :

- une unité de stockage 13 du vecteur des normes relatives à tous les neurones de sortie,
- un élévateur au carré 24 déterminant des premiers termes $(\delta C_{kl})^2$ concernant les 1 neurones d'entrée du neurone de sortie k,
- un organe de multiplication déterminant des seconds termes $2C_{kl}\cdot\delta C_{kl}$ correspondants,
- un sommateur 25 qui reçoit :

  . l'ancienne norme $m_k$ à partir de l'unité de stockage 13,
  . les premiers termes $(\delta C_{kl})^2$,
  . les seconds termes $2C_{kl}\cdot\delta C_{kl}$.

Le sommateur 25 calcule ainsi la nouvelle norme $m_k^{(n)}$ tel que :

$$m_k^{(n)} = m_k + \sum 2C_{kl}\cdot\delta C_{kl} + \sum(\delta C_{kl})^2$$

et la réécrit dans l'unité de stockage 13 à la place de l'ancienne norme $m_k$ pour être utilisée à un cycle ultérieur.

Les figures 1A et 1B sont présentées sous la forme d'un réseau de neurones formée de blocs fonctionnels. Il est possible que l'ensemble des fonctions à réaliser soit intégré à un calculateur. Dans ce cas l'invention concerne un calculateur programmé pour effectuer l'apprentissage d'un réseau de neurones en mettant en oeuvre le procédé de calcul de la norme selon l'invention.

**Revendications**

1. Procédé de traitement mis en oeuvre dans une structure de réseau de neurones qui détermine des potentiels $Y_k$ de neurones de sortie k à partir des états $x_l$ de neurones d'entrée l qui leur sont connectés selon des coefficients synaptiques $C_{kl}$, et qui effectue des phases d'apprentissage du réseau de neurones en déterminant des coefficients synaptiques nouveaux $C_{kl}^{(n)}$ caractérisé en ce que le procédé effectue un calcul de la norme

$$m_k^{(n)} = \sum_l (C_{kl}^{(n)})^2$$

des nouveaux coefficients synaptiques en additionnant à la norme des coefficients synaptiques précédents des termes relatifs aux mises à jour desdits coefficients synaptiques précédents.

2. Procédé selon la revendication 1 caractérisé en ce qu'il comprend les étapes suivantes :

   A - détermination des potentiels $y_k$ des neurones de sortie k tel que :

   $$y_k = \sum_l C_{kl}\cdot x_l$$

   $B_1$ - mise en oeuvre des étapes d'apprentissage et détermination des variations subséquentes $\Delta_k$ à affecter aux états de neurones d'entrée,
   $B_2$ - par ailleurs, détermination pour un neurone de sortie k de la norme $(x_l)^2$ des états de neurones d'entrée qui convergent sur le neurone k,
   C - détermination de la norme $m_k^{(n)}$ tel que :

7

$$m_k^{(n)} = m_k + 2\,\Delta_k \cdot y_k + (\Delta_k)^2 \cdot \sum_l (x_l)^2$$

où $m_k$ est la norme précédente.

3. Procédé selon la revendication 1 caractérisé en ce qu'il comprend les étapes suivantes :

- détermination de premiers termes $(\delta C_{kl})^2$ pour chaque correction $\delta C_{kl}$ à appliquer à chaque coefficient synaptique $C_{kl}$ d'un neurone de sortie k,
- détermination de seconds termes $2C_{kl}.\delta C_{kl}$ correspondants,
- lecture de la norme précédente dans une unité de stockage de normes,
- sommation de ces premiers et seconds termes et de la norme précédente pour tous les coefficients synaptiques se rapportant à un neurone de sortie k pour déterminer la nouvelle norme $m_k^{(n)}$ des nouveaux coefficients synaptiques et mise à jour dans l'unité de stockage de normes.

4. Structure de réseau de neurones munie de moyens de détermination des potentiels $y_k$ de neurones de sortie k à partir des états $x_l$ de neurones d'entrée l qui leur sont connectés selon des coefficients synaptiques $C_{kl}$, et de moyens pour effectuer des phases d'apprentissage du réseau de neurones en déterminant des coefficients synaptiques nouveaux $C_{kl}^{(n)}$ caractérisée en ce qu'elle comprend des moyens de calcul de la norme

$$m_k^{(n)} = \sum_l (C_{kl}^{(n)})^2$$

des nouveaux coefficients synaptiques en additionnant à la norme des coefficients synaptiques précédents des termes relatifs aux mises à jour desdits coefficients synaptiques précédents.

5. Calculateur programmé selon la revendication 4 caractérisée en ce qu'elle comprend :

. une unité de traitement qui détermine les potentiels $y_k$ des neurones de sortie en opérant en parallèle sur tous les neurones d'entrée l tel que :

$$y_k = \sum_l C_{kl} \cdot x_l$$

et qui détermine les termes relatifs auxdites mises à jour pour calculer des nouveaux coefficients synaptiques $C_{kl}^{(n)}$ tel que :

$$C_{kl}^{(n)} = C_{kl} + \Delta_k \cdot x_l$$

où $\Delta_k$ est un incrément lié au neurone de sortie k,
. une unité de stockage du vecteur des normes précédentes $m_k$ relatives à chaque neurone de sortie k,
. une unité de calcul de la norme

$$\sum_l (x_l)^2$$

de chaque vecteur d'états $x_l$,
. une unité de calcul qui détermine les nouvelles normes $m_k^{(n)}$ à partir des normes

$$\sum_{l} (x_l)^2 ,$$

et des incréments $\Delta_k$ et des potentiels des neurones de sortie $y_k$ issus de l'unité de traitement tel que :

$$m_k^{(n)} = m_k + 2 \Delta_k \cdot y_k + (\Delta_k)^2 \cdot \sum_{l} (x_l)^2 .$$

6. Structure selon la revendication 4 caractérisée en ce qu'elle comprend :

   - une unité de stockage du vecteur de normes précédentes $m_k$ relatives à chaque neurone de sortie k,
   - un élévateur au carré déterminant des premiers termes $(\delta C_{kl})^2$ pour chaque correction à appliquer à chaque coefficient synaptique $C_{kl}$ d'un neurone de sortie k,
   - un organe de multiplication déterminant des seconds termes $2C_{kl} \cdot \delta C_{kl}$ correspondants,
   - un sommateur sommant ces premiers et seconds termes avec la norme précédente $m_k$ pour tous les coefficients synaptiques se rapportant à un neurone de sortie k afin de déterminer la nouvelle norme $m_k^{(n)}$ des nouveaux coefficients synaptiques $C_{kl}^{(n)}$ et mise à jour dans l'unité de stockage de normes.

7. Calculateur programmé pour simuler un réseau de neurones munie de moyens de détermination des potentiels $y_k$ de neurones de sortie k à partir des états $x_l$ de neurones d'entrée l qui leur sont connectés selon des coefficients synaptiques $C_{kl}$, et de moyens pour effectuer des phases d'apprentissage du réseau de neurones en déterminant des coefficients synaptiques nouveaux $C_{kl}^{(n)}$ caractérisé en ce qu'il comprend des moyens de calcul de la norme

$$m_k^{(n)} = \sum_{l} (C_{kl}^{(n)})^2$$

des nouveaux coefficients synaptiques en additionnant à la norme des coefficients synaptiques précédents des termes relatifs aux mises à jour desdits coefficients synaptiques précédents.

8. Calculateur programmé selon la revendication 7 caractérisé en ce qu'il comprend

   . une unité de traitement qui détermine les potentiels $y_k$ des neurones de sortie en opérant en parallèle sur tous les neurones d'entrée l tel que :

$$y_k = \sum_{l} C_{kl} \cdot x_l$$

   et qui détermine les termes relatifs auxdites mises à jour pour calculer des nouveaux coefficients synaptiques $C_{kl}^{(n)}$ tel que :

$$C_{kl}^{(n)} = C_{kl} + \Delta_k \cdot x_l$$

   où $\Delta_k$ est un incrément lié au neurone de sortie k,
   . une unité de stockage du vecteur des normes précédentes $m_k$ relatives à chaque neurone de sortie k,
   . une unité de calcul de la norme

$$\sum_{l} (x_l)^2$$

de chaque vecteur d'états $x_l$,

. une unité de calcul qui détermine les nouvelles normes $m_k^{(n)}$ à partir des normes

$$\sum_l (x_l)^2 ,$$

et des incréments $\Delta_k$ et des potentiels des neurones de sortie $y_k$ issus de l'unité de traitement tel que :

$$m_k^{(n)} = m_k + 2 \Delta_k \cdot y_k + (\Delta_k)^2 \cdot \sum_l (x_l)^2 .$$

9. Calculateur programmé selon la revendication 8 caractérisé en ce qu'il comprend:

- une unité de stockage du vecteur de normes précédentes $m_k$ relatives à chaque neurone de sortie k,
- un élévateur au carré déterminant des premiers termes $(\delta C_{kl})^2$ pour chaque correction à appliquer à chaque coefficient synaptique $C_{kl}$ d'un neurone de sortie k,
- un organe de multiplication déterminant des seconds termes $2C_{kl} \cdot \delta C_{kl}$ correspondants,
- un sommateur sommant ces premiers et seconds termes avec la norme précédente $m_k$ pour tous les coefficients synaptiques se rapportant à un neurone de sortie k afin de déterminer la nouvelle norme $m_k^{(n)}$ des nouveaux coefficients synaptiques $C_{kl}^{(n)}$ et mise à jour dans l'unité de stockage de normes.

## Patentansprüche

1. Ein in einer neuronalen Netzwerkstruktur umgesetztes Verarbeitungsverfahren zur Bestimmung der Potentiale $y_k$ der Ausgangsneuronen k anhand der Zustände $x_l$ der Eingangsneuronen l, mit denen sie nach den synaptischen Koeffizienten $C_{kl}$ in Kontakt stehen, und das über die Bestimmung der neuen synaptischen Koeffizienten $C_{kl}^{(n)}$ am neuronalen Netzwerk Lernphasen vornimmt, mit dem Merkmal, daß das Verfahren eine Berechnung der Norm

$$m_k^{(n)} = \sum_l (C_{kl}^{(n)})^2$$

der neuen synaptischen Koeffizienten vornimmt, indem zu der Norm der vorherigen synaptischen Koeffizienten Ausdrücke in bezug auf die Aktualisierung der besagten vorhergehenden synaptischen Koeffizienten addiert werden.

2. Verfahren laut Anspruch 1, mit dem Merkmal, daß es auf folgenden Schritten besteht :

A - Bestimmung der Potentiale $y_k$ der Ausgangsneuronen k, wie

$$y_k = \sum_l C_{kl} \cdot x_l$$

$B_1$ - Durchführung der Lernschritte und Bestimmung der den Zuständen der Eingangsneuronen zuzuteilenden nachfolgenden Variationen $\Delta_k$,

$B_2$ - Dazu Bestimmung für ein Ausgangsneuron k der Norm $(x_l)^2$ der Zustände der Eingangsneuronen, die zum Neuron k konvergieren,

C - Bestimmung der Norm $m_k^{(n)}$, wie:

$$m_k^{(n)} = m_k + 2\,\Delta_k \cdot y_k + (\Delta_k)^2 \cdot \sum_l (x_l)^2$$

wobei $m_k$ die vorherige Norm ist.

3. Verfahren laut Anspruch 1, mit dem Merkmal, daß es auf folgenden Schritten besteht :

- Bestimmung der ersten Ausdrücke $(\delta C_{kl})^2$ für jede Korrektur $\delta C_{kl}$, an jedem synaptischen Koeffizienten $C_{kl}$ eines Ausgangsneurons k vorzunehmen,
- Bestimmung der zweiten, entsprechenden Ausdrücke $2 C_{kl} \cdot \delta C_{kl}$,
- Lesen der vorhergehenden Norm in einer Norm-Speichereinheit,
- Summierung dieser ersten und zweiten Ausdrücke und der vorhergehenden Norm für alle synaptischen Koeffizienten, die sich auf ein Ausgangsneuron k beziehen, um die neue Norm $m_k^{(n)}$ der neuen synaptischen Koeffizienten zu bestimmen und in der Norm-Speichereinheit zu aktualisieren.

4. Struktur eines neuronalen Netzwerks, das über Mittel verfügt, um die Potentiale $y_k$ der Ausgangsneuronen k anhand der Zustände $x_l$ der Eingangsneuronen l zu bestimmen, mit denen sie nach den synaptischen Koeffizienten $C_{kl}$ in Kontakt stehen, und über Mittel, um über die Bestimmung der neuen synaptischen Koeffizienten $C_{kl}^{(n)}$ am neuronalen Netzwerk Lernphasen vorzunehmen, mit dem Merkmal, daß es über Mittel zur Berechnung der Norm

$$m_k^{(n)} = \sum_l (C_{kl}^{(n)})^2$$

der neuen synaptischen Koeffizienten verfügt, indem zu der Norm der vorherigen synaptischen Koeffizienten Ausdrücke in bezug auf die Aktualisierung der besagten vorhergehenden synaptischen Koeffizienten addiert werden.

5. Struktur laut Ansrpuch 4, mit dem Merkmal, daß sie folgendes enthält :

. Eine Verarbeitungseinheit zur Bestimmung der Potentiale $y_k$ der Ausgangsneuronen durch parallele Verarbeitung aller Eingangsneuronen l, wie :

$$y_k = \sum_l C_{kl} \cdot x_l$$

die dazu die Ausdrücke in bezug auf die besagten Aktualisierungen zur Berechnung der neuen synaptischen Koeffizient $C_{kl}^{(n)}$ bestimmt, wie :

$$C_{kl}^{(n)} = C_{kl} + \Delta_k \cdot x_l$$

wobei $\Delta_k$ ein mit dem Ausgangsneuron k verbundenes Inkrement ist,
. eine Speichereinheit des Vektors der vorhergehenden Normen $m_k$ in bezug auf jedes Ausgangsneuron k,
. eine Recheneinheit für die Norm

$$\sum_l (x_l)^2$$

jedes Zustandsvektors $x_l$,
. eine Recheneinheit zur Bestimmung der neuen Normen $m_k^{(n)}$ anhand der Normen

$$\sum_{l} (x_l)^2$$

und Inkremente $\Delta_k$, sowie der Potentiale der Ausgangsneuronen $y_k$ kommend aus der Verarbeitungseinheit, wie:

$$m_k^{(n)} = m_k + 2\,\Delta_k \cdot y_k + (\Delta_k)^2 \cdot \sum_{l} (x_l)^2.$$

6. Struktur laut Ansrpuch 4, mit dem Merkmal, daß sie folgendes enthält :

- Eine Speichereinheit des Vektors der vorhergehenden Normen $m_k$ in bezug auf jedes Ausgangsneuron k,
- einen Quadrierer zur Bestimmung der ersten Ausdrücke $(\delta C_{kl})^2$, für jede Korrektur an jedem synaptischen Koeffizienten $C_{kl}$ eines Ausgangsneuron k vorzunehmen,
- eine Multiplikationseinheit zur Bestimmung der zweiten, entsprechenden Ausdrücke $2C_{kl} \cdot \delta C_{kl}$,
- einen Summierer zur Summierung dieser ersten und zweiten Ausdrücke mit der vorhergehenden Norm $m_k$ aller synaptischen Koeffizienten, die sich auf ein Ausgangsneuron k beziehen, um die neue Norm $m_k^{(n)}$ der neuen synaptischen Koeffizienten $C_{kl}^{(n)}$ zu bestimmen und in der Norm-Speichereinheit zu aktualisieren.

7. Ein programmierter Rechner zur Simulation eines neuronales Netzwerk, das über Mittel verfügt, um die Potentiale $y_k$ der Ausgangsneuronen k anhand der Zustände $x_l$ der Eingangsneuronen l zu bestimmen, mit denen sie nach den synaptischen Koeffizienten $C_{kl}$ in Kontakt stehen, und über Mittel, um über die Bestimmung der neuen synaptischen Koeffizienten $C_{kl}^{(n)}$ am neuronalen Netzwerk Lernphasen vorzunehmen, mit dem Merkmal, daß es über Mittel zur Berechnung der Norm

$$m_k^{(n)} = \sum_{l} (C_{kl}^{(n)})^2$$

der neuen synaptischen Koeffizienten verfügt, indem zu der Norm der vorherigen synaptischen Koeffizienten Ausdrücke in bezug auf die Aktualisierung der besagten vorhergehenden synaptischen Koeffizienten addiert werden.

8. Ein programmierter Rechner laut Anspruch 7, mit dem Merkmal, daß er folgendes enthält :

. Eine Verarbeitungseinheit zur Bestimmung der Potentiale $y_k$ der Ausgangsneuronen durch parallele Verarbeitung aller Eingangsneuronen l, wie :

$$y_k = \sum_{l} C_{kl} \cdot x_l$$

die dazu die Ausdrücke in bezug auf die besagten Aktualisierungen zur Berechnung der neuen synaptischen Koeffizient $C_{kl}^{(n)}$ bestimmt, wie:

$$C_{kl}^{(n)} = C_{kl} + \Delta_k \cdot x_l$$

wobei $\Delta_k$ ein mit dem Ausgangsneuron k verbundenes Inkrement ist,
. eine Speichereinheit des Vektors der vorhergehenden Normen $m_k$ in bezug auf jedes Ausgangsneuron k,
. eine Recheneinheit für die Norm

$$\sum_{l} (x_l)^2$$

jedes Zustandsvektors $x_l$,

. eine Recheneinheit zur Bestimmung der neuen Normen $m_k^{(n)}$ anhand der Normen

$$\sum_l (x_l)^2$$

und Inkremente $\Delta_k$, sowie der Potentiale der Ausgangsneuronen $y_k$ kommend aus der Verarbeitungseinheit, wie:

$$m_k^{(n)} = m_k + 2\,\Delta_k \cdot y_k + (\Delta_k)^2 \cdot \sum_l (x_l)^2.$$

9. Ein programmierter Rechner laut Anspruch 8, mit dem Merkmal, daß er folgendes enthält :

- Eine Speichereinheit des Vektors der vorhergehenden Normen $m_k$ in bezug auf jedes Ausgangsneuron k,
- einen Quadrierer zur Bestimmung der ersten Ausdrücke $(\delta C_{kl})^2$, für jede Korrektur an jedem synaptischen Koeffizienten $C_{kl}$ eines Ausgangsneuron k vorzunehmen,
- eine Multiplikationseinheit zur Bestimmung der zweiten, entsprechenden Ausdrücke $2C_{kl} \cdot \delta C_{kl}$,
- einen Summierer zur Summierung dieser ersten und zweiten Ausdrücke mit der vorhergehenden Norm $m_k$ aller synaptischen Koeffizienten, die sich auf ein Ausgangsneuron k beziehen, um die neue Norm $m_k^{(n)}$ der neuen synaptischen Koeffizienten $C_{kl}^{(n)}$ zu bestimmen und in der Norm-Speichereinheit zu aktualisieren.

## Claims

1. A processing method carried out in a neural network structure which method determines potentials $y_k$ of output neurons k from states $x_l$ of input neurons l which are linked thereto by synaptic coefficients $C_{kl}$, and performs learning phases of the neural network by determining new synaptic coefficients $C_{kl}^{(n)}$ characterized in that the method calculates the norm

$$m_k^{(n)} = \sum_l (C_{kl}^{(n)})^2$$

of new synaptic coefficients by adding to the norm $m_k$ of preceding synaptic coefficient terms relating to the updating of said preceding synaptic coefficients.

2. A method as claimed in Claim 1, characterized in that it comprises the following steps:

A - determining potentials $y_k$ of output neurons k as:

$$y_k = \sum_l C_{kl} \cdot x_l;$$

B1 - carrying out the learning steps and determining subsequent variations $\Delta_k$ to be assigned to the input neuron states,
B2 - moreover, determining for an output neuron k the norm $(x_l)^2$ of states of input neurons which converge to the neuron k,
C - determining the norm $m_k^{(n)}$ as

$$m_k^{(n)} = m_k + 2\Delta_k \cdot y_k + (\Delta_k)^2 \cdot \sum_l (x_l)^2$$

where $m_k$ is the preceding norm.

3. A method as claimed in Claim 1, characterized in that it comprises the following steps:

- determining first terms $(\delta C_{kl})^2$ for each correction $\delta C_{kl}$ to be applied to each synaptic coefficient $C_{kl}$ of an output neuron k,
- determining corresponding second terms $2.C_{kl}.\delta C_{kl}$,
- reading the preceding norm in a unit for the storage of norms,
- summing said first second terms to and the preceding norm $m_k$ for all synaptic coefficients relating to an output neuron k in order to determine the new norm $m_k^{(n)}$ of new synaptic coefficients and updating in the unit for the storage of norms.

4. A neural network structure comprising means for determining potentials $y_k$ of output neurons k on the basis of states $x_l$ of input neurons l which are coupled thereto by $C_{kl}$, and means for performing learning phases of the neural network by determining new synaptic coefficients $C_{kl}^{(n)}$, characterized in that it comprises means for calculating the norm

$$m_k^{(n)} = \sum_l (C_{kl}^{(n)})^2$$

of new synaptic coefficients by adding to the norm of the preceding synaptic coefficients terms relating to the updating of said preceding synaptic coefficients.

5. A structure as claimed in Claim 4, characterized in that it comprises:

- a processing unit which determines the potentials $y_k$ of output neurons by operating in parallel on all input neurons by operating in parallel on all input neurons l so that:

$$y_k = \sum_l C_{kl} \cdot x_l$$

and determines the terms relating to said updating in order to calculate new synaptic coefficients $C_{kl}^{(n)}$

$$C_{kl}^{(n)} = C_{kl} + \Delta_k \cdot x_l$$

where $\Delta_k$ is an increment relating to the output neuron k,
- a unit for storing the vector of preceding norms $m_k$ relating to each output neuron k,
- a unit for calculating the norm

$$\sum_l (x_l)^2$$

of each vector of states $x_l$,
- a calculating unit which determines the new norms $m_k^{(n)}$ from norms

$$\sum_l (x_l)^2,$$

and increments $\Delta_k$ and potentials of output neurons $y_k$ from the processing unit so that

$$m^{(n)}_k = m_k + 2\Delta_k \cdot y_k + (\Delta_k)^2 \cdot \sum_l (x_l)^2.$$

6. A structure as claimed in Claim 4, characterized in that it comprises:

- a unit for the storage of the vector of preceding norms $m_k$ relating to each output neuron k,
- a squaring member which determines first terms $(\delta C_{kl})^2$ for each correction to be applied to each synaptic coefficient $C_{kl}$ of an output neuron k,
- a multiplying member which determines corresponding second terms $2C_{kl} \cdot \delta C_{kl}$,
- a summing member which sums said first and second terms and the preceding norm $m_k$ for all synaptic coefficients relating to an output neuron k in order to determine the new norm $m^{(n)}_k$ of new synaptic coefficients $C^{(n)}_{kl}$ and updating in the unit for the storage of norms.

7. A programmed computer for simulating a neural network comprising means for determining potentials $y_k$ of output neurons k on the basis of states $x_l$ of input neurons l which are coupled thereto by synaptic coefficients $C_{kl}$, and means for performing learning phases of the neural network by determining new synaptic coefficients $C^{(n)}_{kl}$, characterized in that it comprises means for calculating the norm

$$m^{(n)}_k = \sum_l (C^{(n)}_{kl})^2$$

of new synaptic coefficients by adding to the norm of preceding synaptic coefficients terms relating to the updating of said preceding synaptic coefficients.

8. A programmed computer structure as claimed in Claim 7, characterized in that it comprises:

. a processing unit which determines the potentials $y_k$ of output neurons by operating in parallel on all input neurons l so that:

$$y_k = \sum_l C_{kl} \cdot x_l$$

and determines the terms relating to said updating in order to calculate new synaptic coefficients $C^{(n)}_{kl}$ as:

$$C^{(n)}_{kl} = C_{kl} + \Delta_k \cdot x_l$$

where $\Delta_k$ is an increment relating to the output neuron k,
. a unit for calculating the norm

$$\sum_l (x_l)^2$$

of each vector of states $x_l$,
. a calculating unit which determines the new norms $m^{(n)}_k$ from norms

$$\sum_l (x_l)^2,$$

and increments $\Delta_k$ and potentials of output neurons $y_k$ from the processing unit so that:

$$m^{(n)}_k = m_k + 2\Delta_k \cdot y_k + (\Delta_k)^2 \cdot \sum_l (x_l)^2.$$

9. A programmed computer as claimed in Claim 8, characterized in that it comprises:

- a unit for the storage of the vector of preceding norms $m_k$ relating to each output neuron k,
- a squaring member which determines first terms $(\delta C_{kl})^2$ for each correction to be applied to each synaptic coefficient $C_{kl}$ of an output neuron k,
- a multiplying member which determines corresponding second terms $2C_{kl} \cdot \delta C_{kl}$,
- a summing member which sums said first and second terms and the preceding norm $m_k$ for all synaptic coefficients relating to an output neuron k in order to determine the new norm $m^{(n)}_k$ of new synaptic coefficients $C^{(n)}_{kl}$ and updating in the unit for the storage of norms.

$$C_{kl}^{(n)}$$

$$C_{kl}$$

11　　10

$$Y_k = \sum_l C_{kl} \cdot X_l$$

$$C_{kl}^{(n)} = C_{kl} + \Delta_k \cdot X_l$$

$$\Delta_k \qquad Y_k \qquad X_l$$

$$m_k$$

$$\sum (X_l)^2$$

$$m_k^{(n)}$$

12

13　　15　　14

**FIG.1A**

$$C_{kl}^{(n)}$$

$$C_{kl}$$

11　　10

$$Y_k = \sum_l C_{kl} \cdot X_l$$

$$C_{kl}^{(n)} = C_{kl} + \delta C_{kl}$$

$$\delta C_{kl}$$

$$C_{kl}$$

$$m_k$$

$$\sum$$

$$m_k^{(n)}$$

12

13　　25　　26　　24

**FIG.1B**